Europäisches Patentamt

European Patent Office

Office européen des brevets

Publication number: **0 275 508**
**A1**

## EUROPEAN PATENT APPLICATION

(21) Application number: 87118793.6

(22) Date of filing: **18.12.87**

(51) Int. Cl.⁴ **H01L 21/82**

(30) Priority: **23.12.86 IT 2285386**

(43) Date of publication of application:
**27.07.88 Bulletin 88/30**

(84) Designated Contracting States:
**DE FR GB NL**

(71) Applicant: **SGS MICROELETTRONICA S.p.A.**
**Stradale Primosole 50**
**I-95121 Catania(IT)**

(72) Inventor: **Mazzali, Stefano**
**Via Crema 28**
**I-20135 Milano(IT)**

(74) Representative: **Modiano, Guido et al**
**MODIANO, JOSIF, PISANTY & STAUB**
**Modiano & Associati Via Meravigli, 16**
**I-20123 Milan(IT)**

(54) **Method for making CMOS devices.**

(57) In a method for making CMOS devices after formation of a well region in the substrate, the active regions are delimited by using two active region masks, one for the P type regions and one for the N type regions. These two masks are also used to dope the regions of the substrate and of the well where the insulation regions are to be formed. In this manner, instead of three masks, one for the definition of the active regions and two for implanting atoms in the insulation regions, only two masks are sufficient.

FIG. 3

EP 0 275 508 A1

# METHOD FOR MAKING CMOS DEVICES

The present invention relates to a method for making CMOS devices.

As is known, Complementary Metal Oxide Silicon (CMOS) technology has been playing for some years an important role in the integrated circuit industry. In this technology, after creating a deep P or N doped region in an originally N or P doped substrate, both P-channel and N-channel transistors are formed. In this manner it is possible to provide logical circuits with a virtually nil power consumption in stationary conditions. Moreover, among the advantages of CMOS structures one must mention high switching speed, compatibility with bipolar devices and immunity to radiations. However, besides problems of latch-up of parasite SCR structures due to the presence of a deep well, CMOS circuits are less dense and more complicated than MOS integrated circuits which employ only one type of transistor. This entails, among other things, the need for a greater number of layers forming the basic device and most of all of the required maskings. Typically, in fact an NMOS structure comprises seven layers obtained by using five masking steps, while a CMOS structure comprises twelve layers and requires ten masking steps.

In particular, as will be explained in greater detail hereinafter, a method currently used for making CMOS devices generally comprises forming the well in a substrate doped in the opposite manner, definition of the active regions by means of an appropriate mask, and two successive masking steps for implanting different atoms (typically boron and phosphorus) for forming the insulation regions with opposite conductivity. The method furthermore comprises further steps for forming the source and drain regions of the two complementary transistors as well as their gates, the metalizations and the dielectric layer comprised between the gate regions and the metalization layers.

As above said, the overall method for making CMOS structures thus requires ten masking steps, so that the finished CMOS device has preset production costs.

However, in view of the relatively high cost of each masking step, the need is felt to modify the basic production method so as to reduce the number of manufacturing steps, in particular of the masking steps.

Accordingly, the aim of the present invention is to provide a method for making CMOS devices which allows reduction of the production steps, and in particular of the masking steps.

Within this aim, a particular object of the present invention is to provide a method which comprises method steps which are per se currently known and used in the manufacture of integrated devices. and which requires the use of machines currently in use in the electronics industry.

Not least object of the present invention is to provide a method which provides devices having electric behaviour which is comparable or even improved with respect to the devices made according to known methods.

The above aim and objects as well as other objects which will become apparent hereinafter are achieved by a method for making CMOS devices, according to the invention, as defined in the claims.

The characteristics and advantages of the invention will become apparent from the description of a preferred, but not exclusive, embodiment, illustrated only by way of non-limitative example in the accompanying drawings, wherein:

Figures 1a to 1m illustrate various procedural steps of the method according to the invention and are cross section views through a semiconductor wafer accommodating the different layers for the obtainment of a CMOS structure, according to the prior art;

Figure 2 is a cross section view through a semiconductor wafer accommodating a finished CMOS structure; and

Figures 3a to 3j are cross section views through a material wafer illustrating the steps of the method according to the invention.

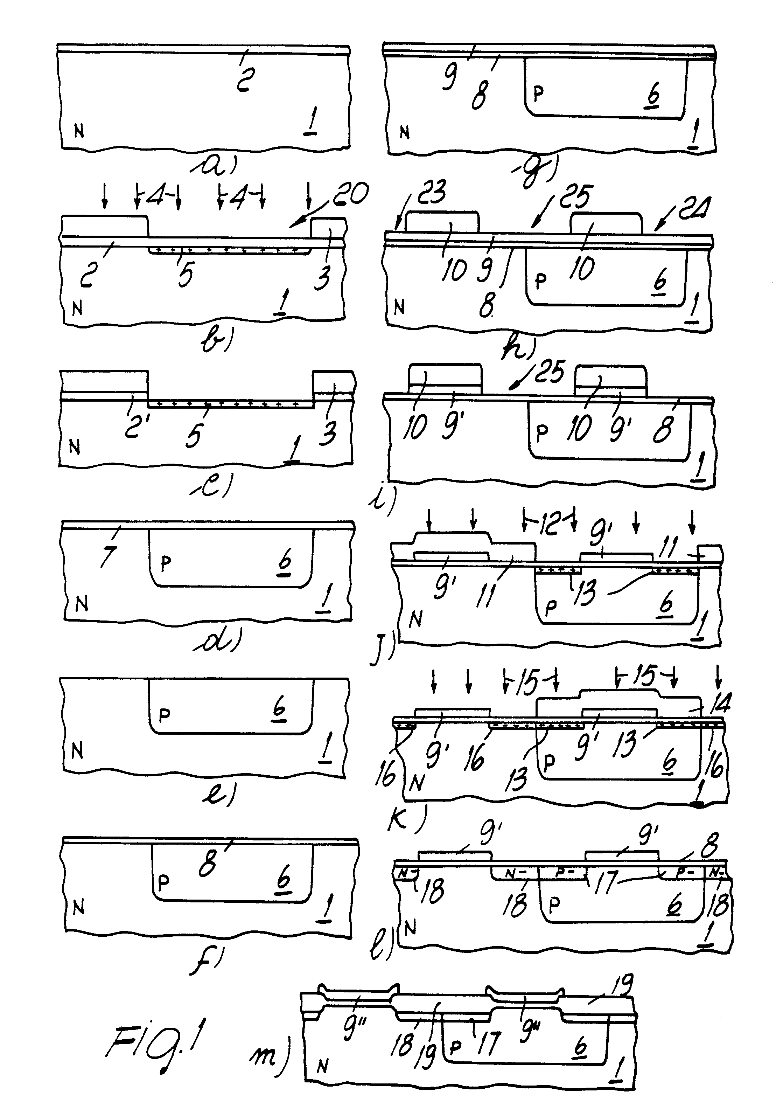

Reference is initially made to figures 1a to 1m, illustrating the fabrication steps according to a known method up to forming the field oxide layer.

In detail, starting from an N-type silicon wafer with orientation [100] and resistivity 2.5-3.5 Ω cm (indicated in the figures at 1), an initial oxidation is performed which leads to the obtainment of the layer 2 (see fig. 1a) with a thickness of 1700 Å. Then a masking step is performed for the definition of the P-well. A resist layer is then deposited and, by means of photolithographic techniques, a window is formed (indicated at 20 in figure 1b) above the region where the P well is to be obtained. Then boron is implanted, as symbolized by the arrows 4 in figure 1b, showing also the resist mask layer 3, the window 20, and the thin layer 5 symbolizing the implanted boron atoms. Subsequently the oxide layer is etched away for removing the part of oxide layer 2 which is not covered by the mask 3, thus the structure of figure 1c is obtained, where the remaining oxide layer is indicated at 2'. Then the implanted ions are thermally diffused to obtain the P-well, indicated at 6 in figure 1d. During this step an oxide layer 7 is formed having a thickness of approximately 2700 Å and covering the upper face of the silicon wafer. Then the structure is etched for removing the oxide layer 7, obtaining the structure of figure 1e. Then a second oxidation is performed, leading to the formation of an oxide layer 8 (figure 1f) with a thickness of 900 Å. Then (see fig. 1g) a nitride layer Si3N4, indicated at 9 in the figure, is deposited. Subsequently a masking step is performed to define the active regions, comprising deposition of a resist layer and masking by means of photolithographic techniques for the obtainment of appropriate windows within the mask. The structure of figure 1h is thus obtained in which the resist portions 10 and the windows 23-25 can be seen. In detail, according to the known method, the window indicated at 25 arranged astride the P-well region 6 and the region where the P-channel transistor is to be formed, currently has a minimum width of 7 microns. Then the nitride layer is etched away in the regions not covered by the mask 10 for removing the regions where boron and phosphorus are to be implanted to obtain insulation regions. The structure of figure 1i is thus obtained, in which 9' indicates the remaining nitride portions. Then a masking step is carried out for the obtainment of the P insulation. A mask is then deposited (indicated at 11 in figure 1j) which leaves uncovered only the P-well region and any other regions where P doped regions are to be formed. Then a light boron implant is performed. This step is pointed out in figure 1j, where the arrows 12 symbolize the boron implant, while the thin layers 13 symbolize the implanted boron atoms. As can be seen, during this step the nitride layer 9' portion, which covers the parts of the silicon wafer accommodating the P-well (on the right in the figure), prevents implant of boron ions in that region. Then a resist mask 14 is deposited, as shown in figure 1k. Now the resist mask 14 covers the P-well region, while the nitride layer 9' portion which is not covered by the mask 14 prevents the underlying regions from being implanted, where the P-channel transistors will be formed. Then phosphorus is implanted to obtain the N insulation as symbolized in the figure by the arrows 15 and by the thin layers 16 in which the phosphorus atoms accumulate. Then a thermal step is performed to obtain activation of the implanted impurities leading to the diffusion of the insulations and the formation of the insulation P doped 17 and N doped 18 layers, as illustrated in figure 1l. Then a field oxidation is performed which leads to the formation of the field oxide regions 19 (figure 1m) with deformation of the nitride portions 9". Then the further steps follow for the production of the N-channel transistor inside the P-well and of the P-channel transistor in the substrate to the left of the P-well.

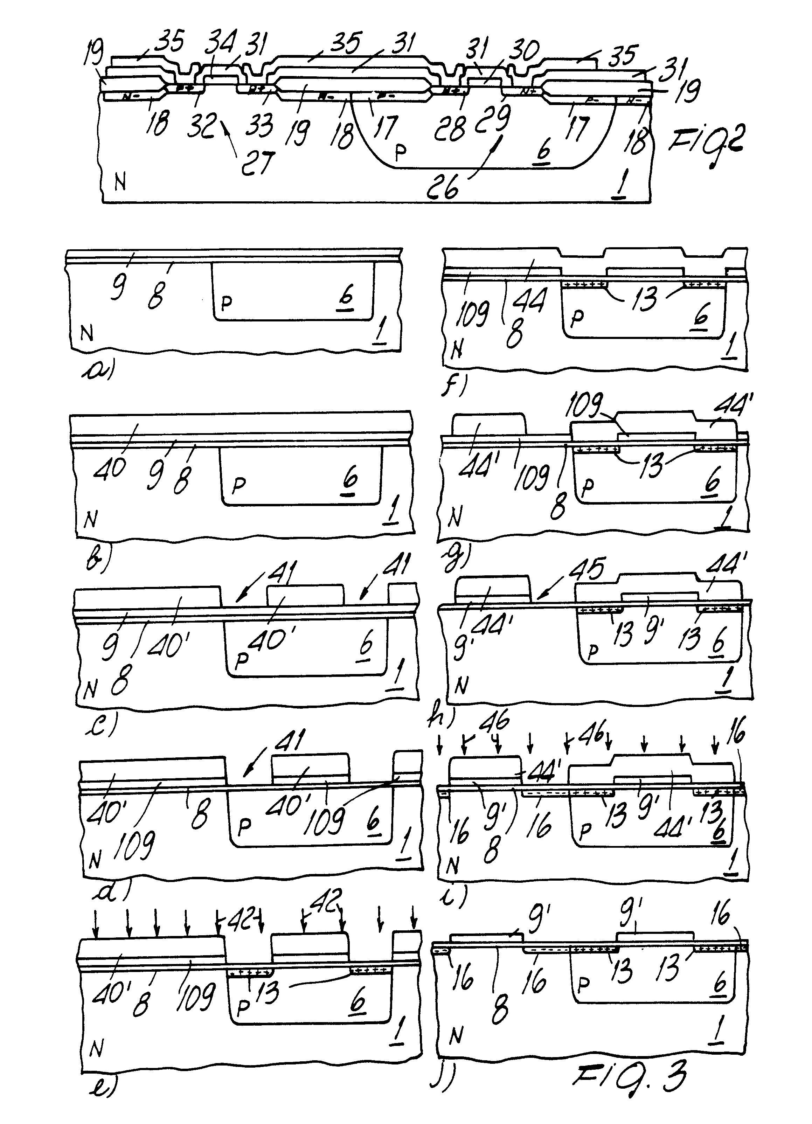

The complete structure is illustrated, for the sake of completeness, in figure 2, comprising, besides the layers already described and indicated by the same reference numerals of figure 1, the N conductivity type layer 28 defining the drain of the N-channel transistor 26, the layer 29, again of the N type defining the source, as well as the gate layer 30 of the same transistor, and the P type layer 32 which defines the source of the P-channel transistor 27, the layer 33, again of the P type, which defines the drain and the layer 34 forming the gate of this transistor 27. The dielectric layer 31 and the metalization layer 35 complete the structure.

In its entirety, the structure of figure 2 therefore requires ten masking steps, of which three, as indicated in the description of figure 1a to 1m, for defining the active regions and for forming the P and N insulation regions.

According to the invention, it is instead possible to define the active regions and to form the insulation by means of only two masking steps.

The invention initially comprises method steps which are identical to those according to the prior art, up to the formation of the P-well and to the deposition of the nitride layer 9. These steps have not been illustrated, and figure 3a already illustrates the structure corresponding to figure 1g, with respect whereto the same reference numerals have been kept for the sake of uniformity. Starting therefore from the structure comprising the N-type substrate 1, the P-well region 6, the oxide layer 8 and the nitride layer 9, the main face of the silicon wafer is first covered by a resist layer, as indicated at 40 in figure 3b. Then masking step is performed by the ordinary photolithographic methods which lead to the obtainment of the structure illustrated in figure 3c, showing the remaining resist portions 40' which define appropriate windows 41. As can be noted, here the windows 41 extend only at the P-well in the region where the insulations are to be provided, in practice defining the active region of only the P region. In this case, therefore, the windows 41 have a length which is substantially equal to half the width of window 25 of figure 1h, i.e. 3.5 $\mu$m ± 0.2$\mu$m. Then the nitride portion arranged at the windows 41 is etched away, as illustrated in figure 3d, where the remaining nitride regions are indicated at 109. This mask for defining the active region for the P region is then used to implant insulating boron. This step is illustrated in fig. 3e, in which the arrows 42 symbolize the boron implant, while the thin layers 13 symbolize the implanted boron atoms, using the same notation of figure 1j. The resist mask 40' is then removed and photoresist is further deposited, leading to the obtainment of the layer indicated at 44 in figure 3f. Then a masking step follows for the definition of the active region of only the N region, according to ordinary photolithographic techniques. Thus the structure of figure 3g is obtained, wherein 44' indicates the

portions of the resist layer which cover the P-well region and the active region where the P-channel transistor is to be formed. Then the exposed nitride portions are etched away, forming a window 45 in the nitride layer 109. Also in this case the window 45 has a width approximately equal to half the window 25 of figure 1j, and more precisely equal to 3.5 $\mu$m $\pm$ 0.2 $\mu$m. Then phosphorus is implanted for forming of the N insulation. Said implant is symbolized in figure 3i by the arrows 46, while the small layers 16 indicate here, too, the accumulated phosphorus atoms. Then the resist layer 44 is removed, thus obtaining the structure of figure 3j showing the N-type substrate 1, the P-well region 6, the small layers 13 and 16 accommodating the implanted boron and phosphorus atoms, the covering layer 8 as well as the nitride portions 9' which cover the active regions of the N-channel and P-channel transistors which are to be formed. This structure corresponds to that of figure 1l and is subject to the conventional further steps for manufacturing the device, as described above for forming the field oxide as well as the source, drain and gate regions of the two transistors, and the protection and metalization layers.

As can be seen, according to the method illustrated in figure 3, for defining the active regions and forming the insulation regions only two masking steps are sufficient, instead of the three required by the prior art. This is achieved by separately defining the N-type and P-type active regions by means of a respective mask which is also used for implanting the atoms required to form the insulation. In this manner elimination of one mask is therefore achieved in the overall process for the production of CMOS devices, with the advantages related thereto of reduction of the manufacturing costs and therefore of the finished product.

The fact is stressed that the invention also allows the achievement of important advantages. In fact, during boron and phosphorus implant for the obtainment of the P and N insulations, since a portion of the resist also covers the non-etched nitride regions (see figs. 3c and 3e in comparison with the respective figures 1j and 1k of the known method), a greater screening effectiveness against implanted ions is achieved. This therefore allows an increase in the implant energy, which leads to an increase in the efficiency of the channel-stopper below the field oxide. By virtue of the increased screening, if the dose of implanted atoms is also increased, a rise in the threshold voltage of the field parasite transistor occurs, always compatibly with the break-down voltage required for said transistor.

Though in the process according to the invention two separate nitride etchings are required, instead of one as in the prior art, the method according to the invention is economically more advantageous. However, due to the selectivity of the first nitride etching on the oxide, said oxide (initially 900 Å thick) will have a thickness comprised between 500 and 700 Å after etching, so that there is the risk of removing all the remaining oxide in the second nitride etching, if the N-type active region mask is badly located. This can lead to a phosphorus implant directly on the uncovered silicon; however this does not constitute a serious disadvantage.

A possible problem may arise from the alignment of the two masks for the separate definition of the two active regions. It is therefore necessary to widen the windows in the nitride, leading to a relaxation in the lay-out rules. Accordingly, the dimensions of the active regions are intentionally relaxed by an amount which depends on the process being used and on the exposure machines (typically by an amount approximately equal to 1 micron) so as to intentionally overlap the two active region masks, with a possible phosphorus implant on the uncovered silicon, as above mentioned.

As is apparent from the previous description, the invention fully achieves the intended aims. A method has been in fact described which allows fabricating CMOS devices with a lower number of the required masking steps. The finished device substantially has the same electric characteristics as the devices produced according to the prior art, if not even better when the energy and the implanting doses are increased.

The invention thus conceived is susceptible to numerous modifications and variations, all of which are within the scope of the inventive concept.

In particular, it should be pointed out that the same steps are required for forming more transistors in the same well or more transistors in the same substrate region. This is possible, if required, by implanting, with a same mask, both the impurities intended to form the insulation at the edge region of the well or the substrate (as illustrated in the above embodiment) and the impurities intended to form the insulations between the transistors to be formed in the same well or substrate region. Of course in this case a same transistor type (either N-channel or P-channel) is formed in a same well or substrate region.

Furthermore the sequence of the masking and insulation forming steps may be reversed, by first defining the active region(s) in the substrate and forming the insulation regions therein, and then defining the active region(s) in the well(s) and forming the insulation regions therein.

Moreover, all the details may be replaced with other technically equivalent elements.

## Claims

1. A method for making CMOS devices comprising:
- in a semiconductor wafer having one main face and including a substrate having a first conductivity type, forming a well of a second conductivity type, substantially opposite to said first conductivity type;
- masking said main face of said semiconductor wafer for defining active regions of CMOS-transistors and for forming insulation regions with opposite conductivity types in said substrate and in said well at least at lateral edge portions of said well, and
- forming at least one N-channel transistor and one P-channel transistor in said substrate and in said well, characterized in that said masking step comprises:
- on said main face of said semiconductor wafer depositing a first mask for defining the active region in said well;
- introducing first conductivity determining impurities in said well through first openings in said first mask to form the insulation regions of said second conductivity type within said well;
- on said main face of said semiconductor wafer, depositing a second mask for defining the active region in said substrate,
- introducing further conductivity determining impurities in said substrate through second openings in said second mask to form the insulation regions of said first conductivity type in said substrate and
- diffusing said first and further impurties in said substrate and in said well and forming said insulation regions.

2. A method according to claim 1, characterized in that said first mask is deposited before said second mask.

3. A method according to claim 1, characterized in that said second mask is deposited before said first mask.

4. A method according to one or more of the preceding claims, characterized in that said first mask deposition step comprises depositing a resist layer on said main face of said semiconductor wafer, and photolithographically masking said resist layer to obtain said first openings in said resist layers, said first openings facing said well at edge regions thereof and/or inside said well.

5. A method according to one or more of the preceding claims, characterized in that said second mask deposition step comprises depositing a resist layer on said main face of said semiconductor wafer, photolithographically masking said resist layer to obtain said second openings in said resist layer, said second openings facing said substrate at regions thereof adjacent and/or not adjacent to the edge regions of said well and at lateral and/or non-lateral insulation regions of the transistors to be formed in said substrate.

6. A method according to one or more of the preceding claims, comprising depositing an oxide layer above said main face of said semiconductor wafer and depositing a nitride layer above said oxide layer after said well has been formed, characterized in that after said masking step and before said impurities introduction step, the portions of said nitride layer facing said openings are etched away for defining said active regions.

Fig.1

FIg2

FIG. 3

European Patent Office

# EUROPEAN SEARCH REPORT

Application Number

EP 87 11 8793

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PATENT ABSTRACTS OF JAPAN, vol. 6, no. 144 (E-122)[1022], 3rd August 1982; & JP-A-57 66 659 (TOKYO SHIBAURA DENKI K.K.) 22-04-1982 * Whole abstract * | 1-6 | H 01 L 21/82 |
| X | PATENT ABSTRACTS OF JAPAN, vol. 10, no. 233 (E-427)[2289], 13th August 1986; & JP-A-61 65 471 (TOSHIBA CORP.) 04-04-1986 * Whole abstract * | 1-6 | |
| X | PATENT ABSTRACTS OF JAPAN, vol. 10, no. 201 (E-419)[2257], 15th July 1986; & JP-A-61 44 456 (FUJITSU LTD) 04-03-1986 * Whole abstract * | 1-6 | |

TECHNICAL FIELDS SEARCHED (Int. Cl.4)

H 01 L

The present search report has been drawn up for all claims

| Place of search | Date of completion of the search | Examiner |
|---|---|---|
| THE HAGUE | 23-03-1988 | GELEBART Y.C.M. |

EPO FORM 1503 03.82 (P0401)